# EUROPEAN PATENT APPLICATION

(11) **EP 4 009 384 A1**
(43) Date of publication of application: **08.06.2022**
(21) Application number: 19939915.5
(22) Date of filing: 25.11.2019
(51) Int. Cl.: H01L 31/04

(54) **SOLAR CELL STRING, SOLAR CELL MODULE, SOLAR CELL SHEET AND MANUFACTURING METHOD THEREFOR**

(30) Priority: 01.08.2019 CN 201910707068
(71) Applicant: Longi Solar Technology (Taizhou) Co., Ltd., Taizhou, Jiangsu 225300 (CN)
(72) Inventor: WANG, Biao, Taizhou, Jiangsu 225300 (CN); WANG, Jianbo, Taizhou, Jiangsu 225300 (CN); ZHU, Chen, Taizhou, Jiangsu 225300 (CN); LV, Jun, Taizhou, Jiangsu 225300 (CN); ZHONG, Chunhua, Taizhou, Jiangsu 225300 (CN); YANG, Fei, Taizhou, Jiangsu 225300 (CN); SHEN, Pinwen, Taizhou, Jiangsu 225300 (CN); SHEN, Pan, Taizhou, Jiangsu 225300 (CN)
(74) Representative: Viering, Jentschura & Partner mbB Patent- und Rechtsanwälte
(86) International application number: PCT/CN2019/120675
(87) International publication number: WO 2021/017334

(57) **Abstract**

A solar-cell string (20), a solar-cell module, a solar cell (10) and a fabricating method thereof. The solar cell (10) includes a sector-shaped cell body, front-surface electrodes (11) and a plurality of fine grid lines (12) are provided at a front surface of the cell body, the front-surface electrodes (11) and the fine grid lines (12) intersect and are electrically connected, back-surface electrodes (13) are provided at a back surface of the cell body, and a quantity of the front-surface electrodes (11) and a quantity of the back-surface electrodes (13) are equal. The solar-cell module includes a plurality of solar-cell strings (20) that are sequentially arranged and are electrically connected to each other, a plurality of protrusions (23) are provided on two sides of the solar-cell strings (20), a depression part (24) is formed between every two neighboring instances of the protrusions (23), and the protrusions (23) of each of the solar-cell strings (20) protrude into the depression parts (24) of neighboring solar-cell strings (20). The present application increases the utilization ratio of the monocrystalline silicon rod, and reduces the production cost.

## Description

The present application claims the priority of the Chinese patent application filed on August 01st, 2019 before the Chinese Patent Office with the application number of 201910707068.6 and the title of "SOLAR CELL STRING, SOLAR CELL MODULE, SOLAR CELL SHEET AND MANUFACTURING METHOD THEREFOR", which is incorporated herein in its entirety by reference.

### TECHNICAL FIELD

The present application generally relates to the field of photovoltaics, particularly relates to the field of photovoltaic modules, and particularly relates to a solar-cell string, a solar-cell module, a solar cell and a fabricating method thereof.

### BACKGROUND

With the development of economy and society, the photovoltaic industry faces a certain challenge, and "reducing the cost and increasing the efficiency" has always been the most important topic of the photovoltaic industry.

The cells used in conventional monocrystalline-silicon photovoltaic modules are of the shape of a rectangle with circular rounded corners, which is the result of the purposes of increasing the utilization ratio of the silicon rod and at the same time compromising the layout of the cell sheets. Because the currently used monocrystalline silicon that is grown by using the czochralski method exists in the form of a round rod, in the process of square cutting of the round rod, the silicon material at the periphery of the round rod is lost. Although such a part of the silicon material may be recovered for subsequent re-pulling, the repetitive process definitely increases the cost on the labor and energy.

### SUMMARY

In view of the above-described defects and deficiencies in the prior art, the present application provides a solar-cell string, a solar-cell module, a solar cell and a fabricating method thereof that reduces the production cost.

In the first aspect, the solar cell according to the present application comprises a sector-shaped cell body, front-surface electrodes and a plurality of fine grid lines are provided at a front surface of the cell body, the front-surface electrodes and the fine grid lines intersect and are electrically connected, back-surface electrodes are provided at a back surface of the cell body, and a quantity of the front-surface electrodes and a quantity of the back-surface electrodes are equal.

In the second aspect, the solar-cell string according to the present application comprises a plurality of solar cells that are connected in series by a conductive adhesive; and
one of cut side surfaces of each of the solar cells is perpendicular to an arrangement direction of the solar cells; or
a center line of each of the solar cells is perpendicular to the arrangement direction of the solar cells.

In the third aspect, the solar-cell string according to the present application comprises a plurality of solar cells that are connected in series by a solder strip; and
one of cut side surfaces of each of the solar cells is perpendicular to an arrangement direction of the solar cells; or
a center line of each of the solar cells is perpendicular to the arrangement direction of the solar cells.

In the fourth aspect, the solar-cell module according to the present application comprises a plurality of solar-cell strings that are sequentially arranged and are electrically connected to each other, a plurality of protrusions are provided on two sides of the solar-cell strings, a depression part is formed between every two neighboring instances of the protrusions, and the protrusions of each of the solar-cell strings protrude into the depression parts of neighboring solar-cell strings.

In the fifth aspect, the method for fabricating a solar cell according to the present application comprises the steps of:
slicing directly a monocrystalline silicon rod prepared by using a czochralski method, to obtain a circular silicon wafer;
performing texturing, diffusing, etching, passivation-film depositing and anti-reflection coating to the silicon wafer;
printing front-surface electrodes and back-surface electrodes at a surface of the silicon wafer, and sintering to obtain a circular cell; and
cutting the circular cell, to obtain sector-shaped solar cells.

In the technical solutions according to the embodiments of the present application, by arranging a plurality of sector-shaped solar cells to form the solar-cell string, arranging a plurality of solar-cell strings to obtain the solar-cell module, and obtaining the sector-shaped solar cells by cutting the circular cell, the utilization ratio of the monocrystalline silicon rod is increased, the production cost is reduced, and the problem of the resource wasting caused by the recovering of the leftover material formation by the square cutting of monocrystalline silicon rods can be solved.

The above description is merely a summary of the technical solutions of the present application. In order to more clearly know the elements of the present application to enable the implementation according to the contents of the description, and in order to make the above and other purposes, features and advantages of the present application more apparent and understandable, the particular embodiments of the present application are provided below.

### BRIEF DESCRIPTION OF THE DRAWINGS

In order to more clearly illustrate the technical solutions of the embodiments of the present application or the prior art, the figures that are required to describe the embodiments or the prior art will be briefly introduced below. Apparently, the figures that are described below are embodiments of the present application, and a person skilled in the art can obtain other figures according to these figures without paying creative work.
FIG. 1 is a schematic structural diagram of the three-sliced solar cells obtained by cutting the circular cell by using the method for fabricating a solar cell according to an embodiment of the present application;
FIG. 2 is a schematic structural diagram of the three-sliced solar cells obtained by cutting the circular cell by using the method for fabricating a solar cell according to an embodiment of the present application;
FIG. 3 is a schematic structural diagram of the four-sliced solar cells obtained by cutting the circular cell by using the method for fabricating a solar cell according to an embodiment of the present application;
FIG. 4 is a schematic structural diagram of the four-sliced solar cells obtained by cutting the circular cell by using the method for fabricating a solar cell according to an embodiment of the present application;
FIG. 5 is a schematic structural diagram of the five-sliced solar cells obtained by cutting the circular cell by using the method for fabricating a solar cell according to an embodiment of the present application;
FIG. 6 is a schematic structural diagram of the five-sliced solar cells obtained by cutting the circular cell by using the method for fabricating a solar cell according to an embodiment of the present application;
FIG. 7 is a schematic structural diagram of the six-sliced solar cells obtained by cutting the circular cell by using the method for fabricating a solar cell according to an embodiment of the present application;
FIG. 8 is a schematic structural diagram of the six-sliced solar cells obtained by cutting the circular cell by using the method for fabricating a solar cell according to an embodiment of the present application;
FIG. 9 is a schematic structural diagram of the eight-sliced solar cells obtained by cutting the circular cell by using the method for fabricating a solar cell according to an embodiment of the present application;
FIG. 10 is a schematic structural diagram of the eight-sliced solar cells obtained by cutting the circular cell by using the method for fabricating a solar cell according to another embodiment of the present application;
FIG. 11 is a schematic structural diagram of the eight-sliced solar cells obtained by cutting the circular cell by using the method for fabricating a solar cell according to an embodiment of the present application;
FIG. 12 is a schematic structural diagram of the nine-sliced solar cells obtained by cutting the circular cell by using the method for fabricating a solar cell according to an embodiment of the present application;
FIG. 13 is a schematic structural diagram of the nine-sliced solar cells obtained by cutting the circular cell by using the method for fabricating a solar cell according to another embodiment of the present application;
FIG. 14 is a schematic structural diagram of the nine-sliced solar cells obtained by cutting the circular cell by using the method for fabricating a solar cell according to an embodiment of the present application;
FIG. 15 is a schematic structural diagram of the ten-sliced solar cells obtained by cutting the circular cell by using the method for fabricating a solar cell according to an embodiment of the present application;
FIG. 16 is a schematic structural diagram of the ten-sliced solar cells obtained by cutting the circular cell by using the method for fabricating a solar cell according to another embodiment of the present application;
FIG. 17 is a schematic structural diagram of the ten-sliced solar cells obtained by cutting the circular cell by using the method for fabricating a solar cell according to an embodiment of the present application;
FIG. 18 is a schematic structural diagram of the twelve-sliced solar cells obtained by cutting the circular cell by using the method for fabricating a solar cell according to an embodiment of the present application;
FIG. 19 is a schematic structural diagram of the twelve-sliced solar cells obtained by cutting the circular cell by using the method for fabricating a solar cell according to another embodiment of the present application;
FIG. 20 is a schematic structural diagram of the twelve-sliced solar cells obtained by cutting the circular cell by using the method for fabricating a solar cell according to an embodiment of the present application;
FIG. 21 is a schematic structural diagram according to an embodiment of the present application in which the solar cell is a three-sliced solar cell;
FIG. 22 is a schematic structural diagram according to an embodiment of the present application in which the solar cell is a three-sliced solar cell;
FIG. 23 is a schematic structural diagram according to an embodiment of the present application in which the solar cell is a four-sliced solar cell;
FIG. 24 is a schematic structural diagram according to an embodiment of the present application in which the solar cell is a four-sliced solar cell;
FIG. 25 is a schematic structural diagram according to an embodiment of the present application in which the solar cell is an eight-sliced solar cell;
FIG. 26 is a schematic structural diagram according to another embodiment of the present application in which the solar cell is an eight-sliced solar cell;
FIG. 27 is a schematic structural diagram according to an embodiment of the present application in which the solar cell is an eight-sliced solar cell;
FIG. 28 is a schematic structural diagram according to an embodiment of the present application in which the solar cell is a twelve-sliced solar cell;
FIG. 29 is a schematic structural diagram according to an embodiment of the present application in which the solar cell is a twelve-sliced solar cell;
FIG. 30 is a schematic structural diagram according to an embodiment of the present application in which the solar cell is a twelve-sliced solar cell;
FIG. 31 is a schematic structural diagram of two neighboring solar cells in the solar-cell string electrically connected by using a conductive adhesive according to an embodiment of the present application;
FIG. 32 is a schematic structural diagram of the four-sliced solar cells obtained by cutting the circular cell by using the method for fabricating a solar cell according to an embodiment of the present application;
FIG. 33 is a schematic structural diagram of the four-sliced solar cells obtained by cutting the circular cell by using the method for fabricating a solar cell according to an embodiment of the present application;
FIG. 34 is a schematic structural diagram of the six-sliced solar cells obtained by cutting the circular cell by using the method for fabricating a solar cell according to an embodiment of the present application;
FIG. 35 is a schematic structural diagram of the six-sliced solar cells obtained by cutting the circular cell by using the method for fabricating a solar cell according to an embodiment of the present application;
FIG. 36 is a schematic structural diagram of the eight-sliced solar cells obtained by cutting the circular cell by using the method for fabricating a solar cell according to an embodiment of the present application;
FIG. 37 is a schematic structural diagram of the eight-sliced solar cells obtained by cutting the circular cell by using the method for fabricating a solar cell according to an embodiment of the present application;
FIG. 38 is a schematic structural diagram of the twelve-sliced solar cells obtained by cutting the circular cell by using the method for fabricating a solar cell according to an embodiment of the present application;
FIG. 39 is a schematic structural diagram of the twelve-sliced solar cells obtained by cutting the circular cell by using the method for fabricating a solar cell according to an embodiment of the present application;
FIG. 40 is a schematic structural diagram according to an embodiment of the present application in which the solar cell is a four-sliced solar cell;
FIG. 41 is a schematic structural diagram according to an embodiment of the present application in which the solar cell is a four-sliced solar cell;
FIG. 42 is a schematic structural diagram according to an embodiment of the present application in which the solar cell is a six-sliced solar cell;
FIG. 43 is a schematic structural diagram according to an embodiment of the present application in which the solar cell is a six-sliced solar cell;
FIG. 44 is a schematic structural diagram according to an embodiment of the present application in which the solar cell is an eight-sliced solar cell;
FIG. 45 is a schematic structural diagram according to an embodiment of the present application in which the solar cell is an eight-sliced solar cell;
FIG. 46 is a schematic structural diagram according to an embodiment of the present application in which the solar cell is a twelve-sliced solar cell;
FIG. 47 is a schematic structural diagram according to an embodiment of the present application in which the solar cell is a twelve-sliced solar cell;
FIG. 48 is a schematic structural diagram of two neighboring solar cells in the solar-cell string electrically connected by using a solder strip according to an embodiment of the present application;
FIG. 49 is a schematic structural diagram according to an embodiment of the present application in which the solar cells in the solar-cell string are three-sliced solar cells;
FIG. 50 is a schematic structural diagram according to an embodiment of the present application in which the solar cells in the solar-cell string are four-sliced solar cells;
FIG. 51 is a schematic structural diagram according to an embodiment of the present application in which the solar cells in the solar-cell string are eight-sliced solar cells;
FIG. 52 is a schematic structural diagram according to an embodiment of the present application in which the solar cells in the solar-cell string are eight-sliced solar cells;
FIG. 53 is a schematic structural diagram according to an embodiment of the present application in which the solar cells in the solar-cell string are twelve-sliced solar cells;
FIG. 54 is a schematic structural diagram according to an embodiment of the present application in which the solar cells in the solar-cell string are twelve-sliced solar cells;
FIG. 55 is a schematic structural diagram according to an embodiment of the present application in which the solar cells in the solar-cell string are four-sliced solar cells;
FIG. 56 is a schematic structural diagram according to an embodiment of the present application in which the solar cells in the solar-cell string are six-sliced solar cells;
FIG. 57 is a schematic structural diagram according to an embodiment of the present application in which the solar cells in the solar-cell string are eight-sliced solar cells;
FIG. 58 is a schematic structural diagram according to an embodiment of the present application in which the solar cells in the solar-cell string are twelve-sliced solar cells;
FIG. 59 is a schematic structural diagram according to an embodiment of the present application in which the solar cells in the solar-cell module are three-sliced solar cells;
FIG. 60 is a schematic structural diagram according to an embodiment of the present application in which the solar cells in the solar-cell module are four-sliced solar cells;
FIG. 61 is a schematic structural diagram according to an embodiment of the present application in which the solar cells in the solar-cell module are eight-sliced solar cells;
FIG. 62 is a schematic structural diagram according to an embodiment of the present application in which the solar cells in the solar-cell module are eight-sliced solar cells;
FIG. 63 is a schematic structural diagram according to an embodiment of the present application in which the solar cells in the solar-cell module are twelve-sliced solar cells; and
FIG. 64 is a schematic structural diagram according to an embodiment of the present application in which the solar cells in the solar-cell module are twelve-sliced solar cells.

### DETAILED DESCRIPTION

In order to make the objects, the technical solutions and the advantages of the embodiments of the present application clearer, the technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.

It should be noted that, subject to the avoiding of any conflict, the embodiments and the features of the embodiments of the present application may be combined. The present application will be described in detail below with reference to the drawings and the embodiments.

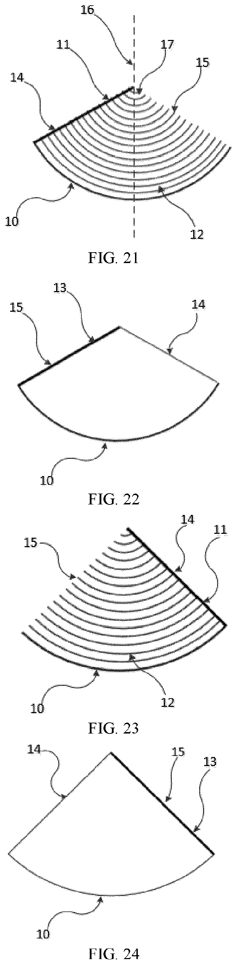

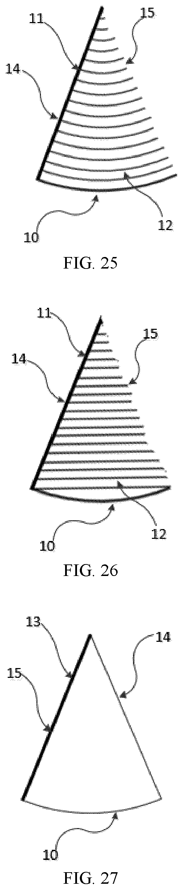

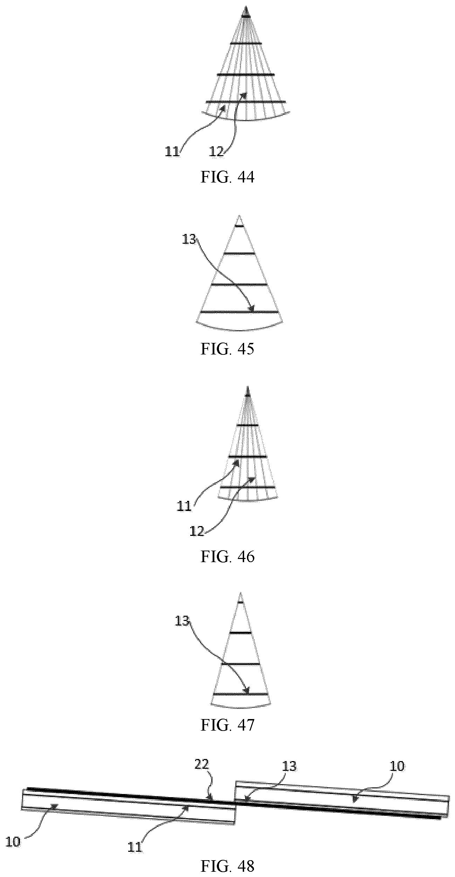

An embodiment of the present application provides, referring to FIGs. 21 to 30 and 40 to 47, a solar cell 10, wherein the solar cell comprises a sector-shaped cell body, front-surface electrodes 11 and a plurality of fine grid lines 12 are provided at the front surface of the cell body, the front-surface electrodes 11 and the fine grid lines 12 intersect and are electrically connected, back-surface electrodes 13 are provided at the back surface of the cell body, and the quantity of the front-surface electrodes 11 and the quantity of the back-surface electrodes 13 are equal.

In an embodiment of the present application, the main bodies of the sector-shaped solar cells are obtained by cutting a circular solar cell, and the circular solar cell is obtained by treating the circular silicon wafer obtained by slicing the monocrystalline silicon rod. The main bodies of the sector-shaped solar cells may be three-sliced pieces, four-sliced pieces, five-sliced pieces, six-sliced pieces, approximately-seven-sliced pieces, eight-sliced pieces, nine-sliced pieces, ten-sliced pieces, approximately-eleven-sliced pieces or twelve-sliced pieces of the circular solar cell. The monocrystalline silicon rod is not required to be square-cut, which reduces the leftover material, and therefore it is not required to recover and reuse the leftover material, which increases the utilization ratio of the monocrystalline silicon rod, and reduces the production cost. The front-surface electrodes and the fine grid lines are provided at the front surface of the cell body. The fine grid lines can collect the electric currents generated by the solar cell. The front-surface electrodes can lead out the electric currents in the fine grid lines. Back-surface electrodes are provided at a back surface of the cell body, and after the front-surface electrodes and the back-surface electrodes of two solar cells have been electrically connected, the two solar cells are connected in series. The quantity of the front-surface electrodes and the quantity of the back-surface electrodes are equal, which facilitates to correspondingly connect the front-surface electrodes and the back-surface electrodes of different solar cells, reduces the wasting by idleness of the front-surface electrodes or the back-surface electrodes, and reduces the production cost of the solar cells.

Referring to FIGs. 21 to 30, in some embodiments, the cell body comprises a first cut side surface 14 and a second cut side surface 15, the front-surface electrodes 11 are arranged along one side of the front surface of the cell body that is closer to the first cut side surface 14, and the back-surface electrodes 13 are arranged along one side of the back surface of the cell body that is closer to the second cut side surface 15.

In an embodiment of the present application, when the solar cells are being stacked, by electrically connecting the back-surface electrodes of the solar cell located above and the front-surface electrodes of the solar cell located below, the area of the overlapping region can be reduced, to reduce the blocking of the light receiving face of the solar cell located below by the solar cell located above. An embodiment may comprise but is not limited to overlapping the edge parts of two solar cells, and spread-coating a conductive adhesive between the two solar cells, to connect the two solar cells in series. The stacking technique of the solar cell can enable the solar cells to be arranged more closely, increase the effective usable area of the solar-cell module, and can increase the output power of the solar-cell module.

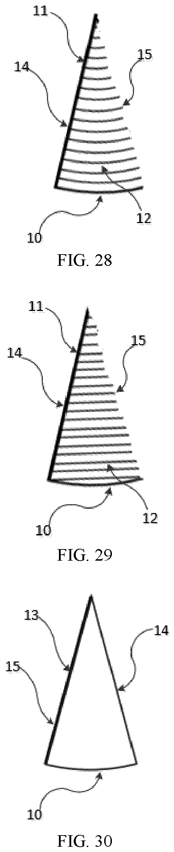

Referring to FIG. 29, in some embodiments, the plurality of fine grid lines 12 are parallel to each other, and the center line 16 of the cell body is perpendicular to the fine grid lines 12.

In an embodiment of the present application, the fine grid lines are straight lines, which can reduce the length of a single fine grid line, and can also reduce the degree of the complexity of the pattern of screen printing, reduce the difficulty in the processing of the solar cells, and reduce the production cost. An embodiment may comprise but is not limited to that the distances between every two neighboring fine grid lines are equal, and the fine grid lines are distributed at the front surface of the solar cell evenly.

Referring to FIGs. 21, 23, 25 and 28, in some embodiments, the plurality of fine grid lines 12 are concentric circular arcs with the vertex of the central angle 17 of the cell body as the circle center.

In an embodiment of the present application, the fine grid lines are circular arcs, so that the fine grid lines can be distributed at the front surface of the solar cell as evenly as possible, whereby the fine grid lines can collect the electric currents generated by the solar cells as many as possible.

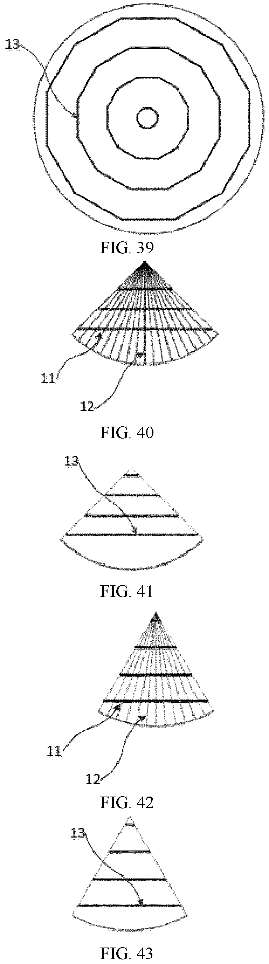

Referring to FIGs. 40 to 47, in some embodiments, all of the front-surface electrodes 11 and the back-surface electrodes 13 are perpendicular to the center line 16 of the cell body, and the front-surface electrodes 11 and the back-surface electrodes 13 are rotationally symmetrical structures.

In an embodiment of the present application, all of the front-surface electrodes and the back-surface electrodes are perpendicular to the center line of the sector-shaped cell body. When the solar cells are being arranged, two neighboring solar cells are reversely placed, so that the front-surface electrodes of one of the solar cells and the back-surface electrodes of the other of the solar cells correspond one to one, and the corresponding front-surface electrode and back-surface electrode are in the same straight line. A solder strip is provided between the front-surface electrodes and the back-surface electrodes, and the front-surface electrodes and the back-surface electrodes are electrically connected by using the solder strip, which can reduce the area of the overlapping region between the two neighboring solar cells, to reduce the blocking of the light receiving face of the solar cell located below by the solar cell located above, and increase the power-generation efficiency of the solar-cell module.

Preferably, the cell body is formed by at least two sub-solar cells that are electrically connected, and the sub-solar cells are obtained by cutting the cell body.

In an embodiment of the present application, the solar cell may be further cut to obtain sub-solar cells, and at least two sub-solar cells may be spliced and connected in series to form the solar cell. For example, one three-sliced solar cell may be formed by splicing two six-sliced sub-solar cells that are obtained by cutting one three-sliced solar cell, and may also be formed by splicing three nine-sliced sub-solar cells that are obtained by cutting one three-sliced solar cell.

Referring to FIGs. 40, 42, 44 and 46, in some embodiments, one end of the fine grid lines 12 is located at the vertex of the central angle 17 of the cell body.

In an embodiment of the present application, an embodiment may comprise but is not limited to that the fine grid lines are distributed at the front surface of the solar cell evenly, and the angles between every two neighboring fine grid lines are equal, whereby the fine grid lines can collect the electric currents generated by the solar cells as many as possible.

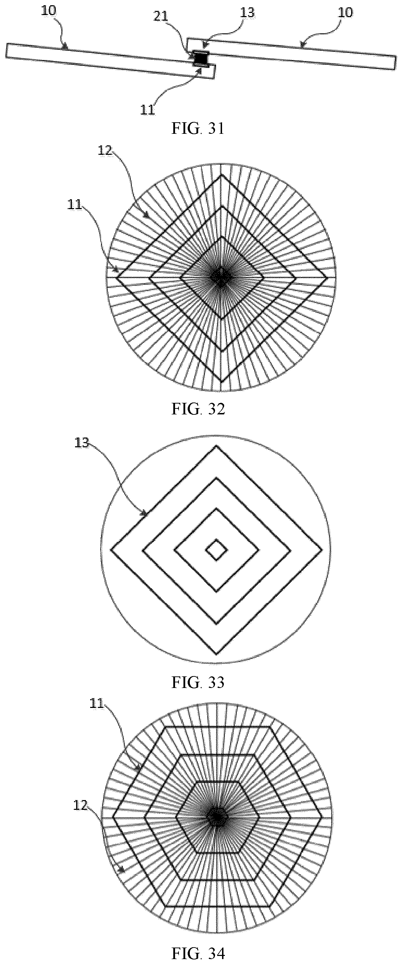

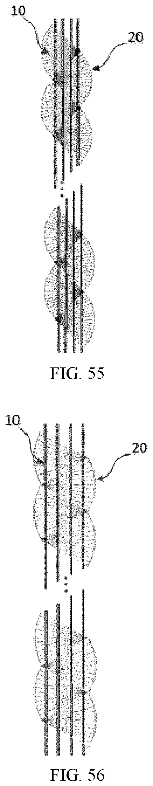

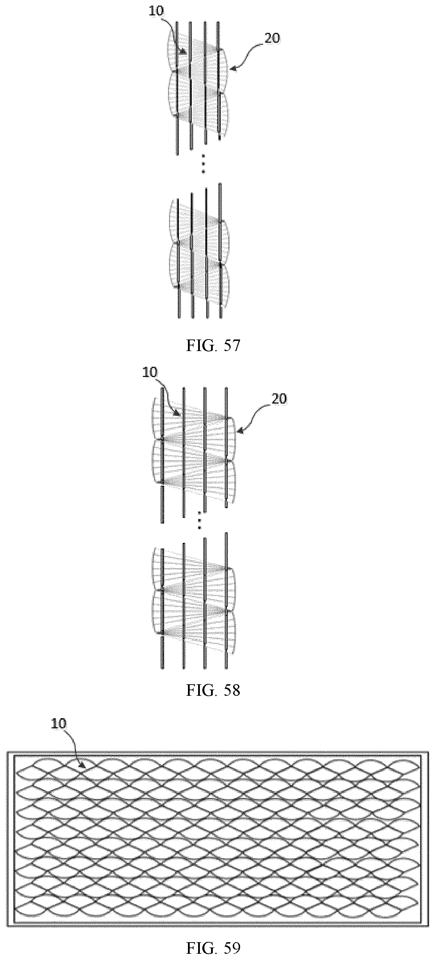

Referring to FIGs. 21 to 31 and 50 to 58, in another embodiment of the present application, a solar-cell string 20, wherein the solar-cell string comprises a plurality of solar cells 10 that are connected in series by a conductive adhesive 21; and
one of the cut side surfaces of each of the solar cells 10 is perpendicular to the arrangement direction of the solar cells 10; or
the center line 16 of each of the solar cells 10 is perpendicular to the arrangement direction of the solar cells 10.

In an embodiment of the present application, the conductive adhesive 21 is provided between two neighboring solar cells 10, and the front-surface electrodes 11 of one of the solar cells 10 and the back-surface electrodes 13 of the other of the solar cells 10 are electrically connected by using the conductive adhesive 21. When the solar cells are being stacked, by electrically connecting the back-surface electrodes of the solar cell located above and the front-surface electrodes of the solar cell located below, the area of the overlapping region can be reduced, to reduce the blocking of the light receiving face of the solar cell located below by the solar cell located above. An embodiment may comprise but is not limited to overlapping the edge parts of two solar cells, and spread-coating a conductive adhesive between the two solar cells, to connect the two solar cells in series. The stacking technique of the solar cell can enable the solar cells to be arranged more closely, increase the effective usable area of the solar-cell module, and can increase the output power of the solar-cell module.

Referring to FIGs. 40 to 48, another embodiment of the present application provides a solar-cell string 20, wherein the solar-cell string comprises a plurality of solar cells 10 that are connected in series by a solder strip 22; and
one of the cut side surfaces of each of the solar cells 10 is perpendicular to the arrangement direction of the solar cells 10; or
the center line 16 of each of the solar cells 10 is perpendicular to the arrangement direction of the solar cells 10.

In an embodiment of the present application, all of the front-surface electrodes and the back-surface electrodes are perpendicular to the center line of the sector-shaped cell body. When the solar cells are being arranged, two neighboring solar cells are reversely placed, so that the front-surface electrodes of one of the solar cells and the back-surface electrodes of the other of the solar cells correspond one to one, and the corresponding front-surface electrode and back-surface electrode are in the same straight line. A solder strip is provided between the front-surface electrodes and the back-surface electrodes, and the front-surface electrodes and the back-surface electrodes are electrically connected by using the solder strip, which can reduce the area of the overlapping region between the two neighboring solar cells, to reduce the blocking of the light receiving face of the solar cell located below by the solar cell located above, and increase the power-generation efficiency of the solar-cell module.

The main bodies of the sector-shaped solar cells are obtained by cutting a circular solar cell, and the circular solar cell is obtained by treating the circular silicon wafer obtained by slicing the monocrystalline silicon rod. The main bodies of the sector-shaped solar cells may be three-sliced pieces, four-sliced pieces, five-sliced pieces, six-sliced pieces, approximately-seven-sliced pieces, eight-sliced pieces, nine-sliced pieces, ten-sliced pieces, approximately-eleven-sliced pieces or twelve-sliced pieces of the circular solar cell. The monocrystalline silicon rod is not required to be square-cut, which reduces the leftover material, and therefore it is not required to recover and reuse the leftover material, which increases the utilization ratio of the monocrystalline silicon rod, and reduces the production cost. The solar-cell string is formed by connecting a plurality of solar cells in series, and all of the areas and the sizes of the solar cells are equal. The neighboring solar cells may be partially overlapped. Particularly, one of the cut side surfaces of each of the solar cells is disposed within the overlapping region, so that the solar cells in the solar-cell string are arranged more closely. Certainly, the solar cell may be further cut to obtain sub-solar cells, and at least two sub-solar cells may be spliced and connected in series to form the solar cell. For example, one three-sliced solar cell may be formed by splicing two six-sliced sub-solar cells that are obtained by cutting one three-sliced solar cell, and may also be formed by splicing three nine-sliced sub-solar cells that are obtained by cutting one three-sliced solar cell.

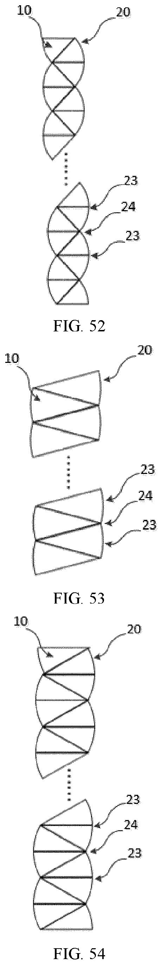

Referring to FIGs. 52 and 54, one of the cut side surfaces of each of the solar cells is perpendicular to the arrangement direction of the solar cells. The solar-cell string with such an arrangement mode of the solar cells has leveled-up edges, and when the solar cells are, but not limited to, six-sliced pieces, eight-sliced pieces, ten-sliced pieces or twelve-sliced pieces of the circular solar cell, this type of arrangement mode is employed.

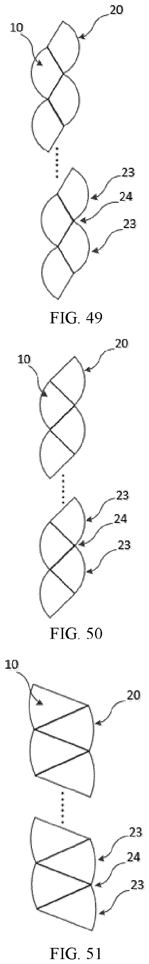

Referring to FIGs. 49 to 51 and 53 to 58, the center line of each of the sector-shaped solar cells is perpendicular to the arrangement direction of the solar cells. Such an arrangement mode has a simple arrangement and facilitates processing and fabrication, and when the solar cells are, but not limited to, three-sliced pieces, four-sliced pieces, five-sliced pieces, six-sliced pieces, approximately-seven-sliced pieces, eight-sliced pieces, nine-sliced pieces, ten-sliced pieces, approximately-eleven-sliced pieces or twelve-sliced pieces of the circular solar cell, this type of arrangement mode is employed.

Referring to FIG. 29, in some embodiments, the plurality of fine grid lines 12 are parallel to each other, and the center line 16 of the solar cell 10 is perpendicular to the fine grid lines 12.

In an embodiment of the present application, the fine grid lines are straight lines, which can reduce the length of a single fine grid line, and can also reduce the degree of the complexity of the pattern of screen printing, reduce the difficulty in the processing of the solar cells, and reduce the production cost. An embodiment may comprise but is not limited to that the distances between every two neighboring fine grid lines are equal, and the fine grid lines are distributed at the front surface of the solar cell evenly.

Referring to FIGs. 21, 23, 25 and 28, in some embodiments, the plurality of fine grid lines 12 are concentric circular arcs with the vertex of the central angle 17 of the solar cell 10 as the circle center.

In an embodiment of the present application, the fine grid lines are circular arcs, so that the fine grid lines can be distributed at the front surface of the solar cell as evenly as possible, whereby the fine grid lines can collect the electric currents generated by the solar cells as many as possible.

Referring to FIGs. 40, 42, 44 and 46, in some embodiments, one end of the fine grid lines 12 is located at the vertex of the central angle 17 of the solar cell 10.

In an embodiment of the present application, an embodiment may comprise but is not limited to that the fine grid lines are distributed at the front surface of the solar cell evenly, and the angles between every two neighboring fine grid lines are equal, whereby the fine grid lines can collect the electric currents generated by the solar cells as many as possible.

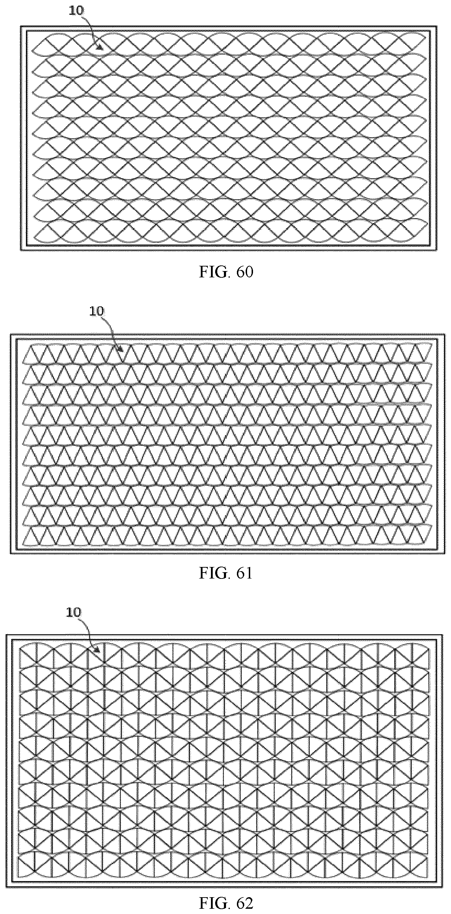

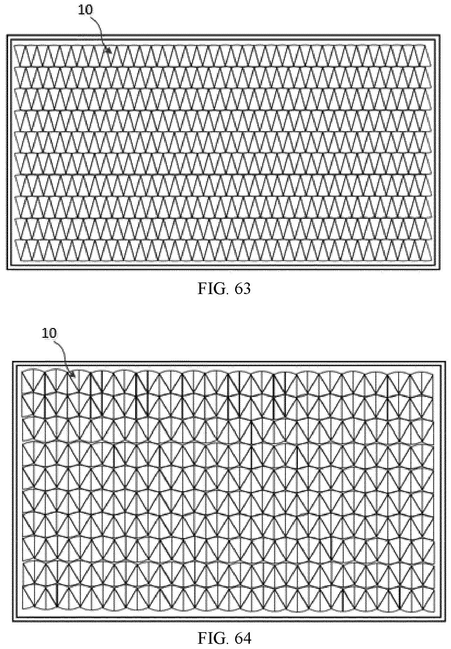

Referring to FIGs. 49 to 64, another embodiment of the present application provides a solar-cell module, wherein the solar-cell module comprises a plurality of solar-cell strings 20 that are sequentially arranged and are electrically connected to each other, a plurality of protrusions 23 are provided on the two sides of the solar-cell strings 20, a depression part 24 is formed between every two neighboring protrusions 23, and the protrusions 23 of each of the solar-cell strings 20 protrude into the depression parts 24 of the neighboring solar-cell strings 20.

In the embodiments of the present application, by arranging the plurality of sector-shaped solar cells to form the solar-cell string, arranging a plurality of solar-cell strings to obtain the solar-cell module, and obtaining the sector-shaped solar cells by cutting the circular cell, the utilization ratio of the monocrystalline silicon rod is increased, and the production cost is reduced. The protrusions of each of the solar-cell strings protrude into the depression parts of the neighboring solar-cell strings, so that the solar-cell strings in the solar-cell module are arranged more closely, and more solar-cell strings can be placed into the solar-cell module of the same area, which increases the effective usable area of the solar-cell module. The solar-cell strings may be connected in series and may also be connected in parallel, and the particular connection mode may be preset according to actual situations.

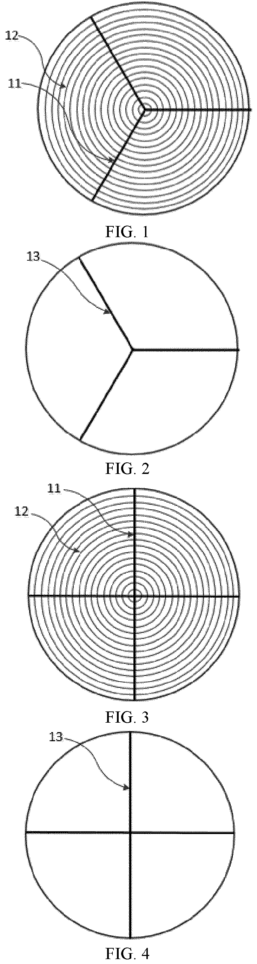

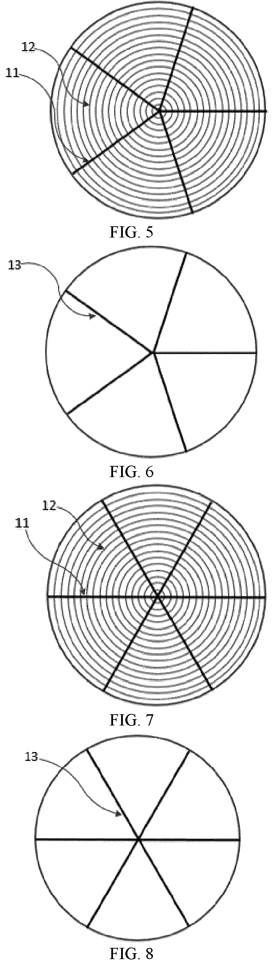

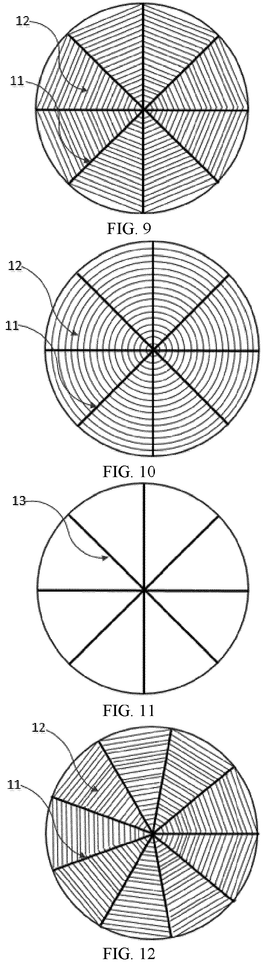

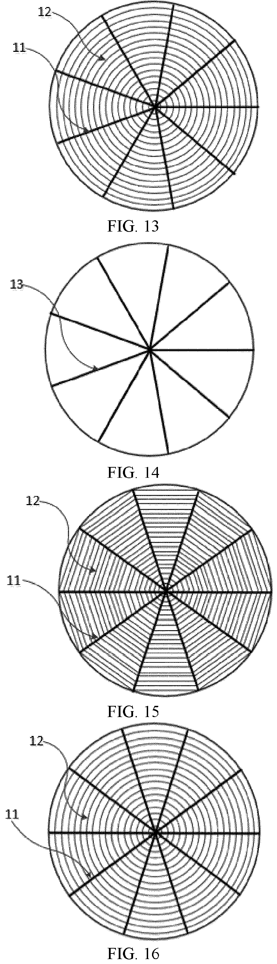

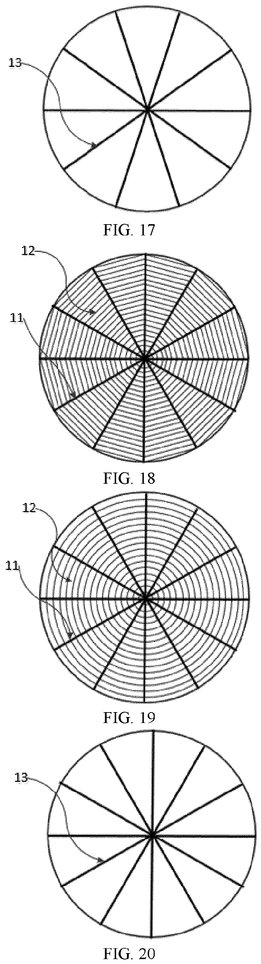

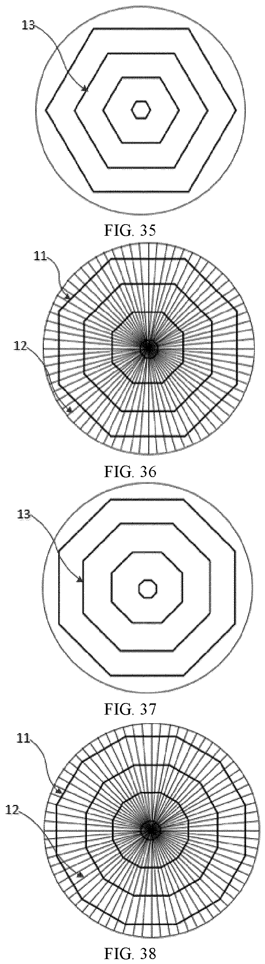

Referring to FIGs. 1 to 30 and 32 to 47, another embodiment of the present application provides a method for fabricating a solar cell, wherein the method comprises the steps of:
slicing directly a monocrystalline silicon rod prepared by using a czochralski method, to obtain a circular silicon wafer;
performing texturing, diffusing, etching, passivation-film depositing and anti-reflection coating to the silicon wafer;
printing front-surface electrodes and back-surface electrodes at a surface of the silicon wafer, and sintering to obtain a circular cell; and
cutting the circular cell, to obtain sector-shaped solar cells.

In an embodiment of the present application, the circular cell is cut, to obtain the sector-shaped solar cells. The sector-shaped solar cells may be three-sliced solar cells, four-sliced solar cells, five-sliced solar cells, six-sliced solar cells, eight-sliced solar cells, nine-sliced solar cells, ten-sliced solar cells or twelve-sliced solar cells. The monocrystalline silicon rod is not required to be square-cut, which reduces the leftover material, and therefore it is not required to recover and reuse the leftover material, which increases the utilization ratio of the monocrystalline silicon rod, and reduces the production cost. The circular cell may be cut into equal parts, and the circular cell may also be cut into unequal parts. For example, one circular cell may be cut into two three-sliced solar cells and two six-sliced solar cells, which may be preset according to actual situations.

The above description is merely description on the preferable embodiments of the present application and the technical principles that are utilized. A person skilled in the art should understand that the scope that is involved in the present application is not limited to the technical solutions that are obtained from the particular combinations of the above technical features, but should also encompass the technical solutions that are formed by the random combinations between the above technical features and their equivalent features without departing from the inventive concept, for example, the technical solutions that are formed by the mutual substitution between the above features and the technical features having the similar functions to those disclosed by (not limited to) the present application.

The "one embodiment", "an embodiment" or "one or more embodiments" as used herein means that particular features, structures or characteristics described with reference to an embodiment are included in at least one embodiment of the present application. Moreover, it should be noted that here an example using the wording "in an embodiment" does not necessarily refer to the same embodiment.

The description provided herein describes many concrete details. However, it can be understood that the embodiments of the present application may be implemented without those concrete details. In some of the embodiments, well-known processes, structures and techniques are not described in detail, so as not to affect the understanding of the description.

In the claims, any reference signs between parentheses should not be construed as limiting the claims. The word "comprise" does not exclude elements or steps that are not listed in the claims. The word "a" or "an" preceding an element does not exclude the existing of a plurality of such elements. The present application may be implemented by means of hardware comprising several different elements and by means of a properly programmed computer. In unit claims that list several devices, some of those devices may be embodied by the same item of hardware. The words first, second, third and so on do not denote any order. Those words may be interpreted as names.

## Claims

1. A solar cell, **characterized in that**, the solar cell comprises a sector-shaped cell body, front-surface electrodes and a plurality of fine grid lines are provided at a front surface of the cell body, the front-surface electrodes and the fine grid lines intersect and are electrically connected, back-surface electrodes are provided at a back surface of the cell body, and a quantity of the front-surface electrodes and a quantity of the back-surface electrodes are equal.

2. The solar cell according to claim 1, **characterized in that**, the cell body comprises a first cut side surface and a second cut side surface, the front-surface electrodes are arranged along one side of the front surface of the cell body that is closer to the first cut side surface, and the back-surface electrodes are arranged along one side of the back surface of the cell body that is closer to the second cut side surface.

3. The solar cell according to claim 1, **characterized in that**, the plurality of fine grid lines are parallel to each other, and a center line of the cell body is perpendicular to the fine grid lines.

4. The solar cell according to claim 1, **characterized in that**, the plurality of fine grid lines are concentric circular arcs with a vertex of a central angle of the cell body as a circle center.

5. The solar cell according to claim 1, **characterized in that**, all of the front-surface electrodes and the back-surface electrodes are perpendicular to a center line of the cell body, and the front-surface electrodes and the back-surface electrodes are rotationally symmetrical structures.

6. The solar cell according to claim 5, **characterized in that**, the cell body is formed by at least two sub-solar cells that are electrically connected, and the sub-solar cells are obtained by cutting the cell body.

7. The solar cell according to claim 1, **characterized in that**, one end of the fine grid lines is located at a vertex of a central angle of the cell body.

8. A solar-cell string, **characterized in that**, the solar-cell string comprises a plurality of solar cells according to any one of claims 1-4 that are connected in series by a conductive adhesive; and
one of cut side surfaces of each of the solar cells is perpendicular to an arrangement direction of the solar cells; or
a center line of each of the solar cells is perpendicular to the arrangement direction of the solar cells.

9. A solar-cell string, **characterized in that**, the solar-cell string comprises a plurality of solar cells according to claim 1 or 5 or 6 or 7 that are connected in series by a solder strip; and
one of cut side surfaces of each of the solar cells is perpendicular to an arrangement direction of the solar cells; or
a center line of each of the solar cells is perpendicular to the arrangement direction of the solar cells.

10. A solar-cell module, **characterized in that**, the solar-cell module comprises a plurality of solar-cell strings according to claim 8 or 9 that are sequentially arranged and are electrically connected to each other, a plurality of protrusions are provided on two sides of the solar-cell strings, a depression part is formed between every two neighboring instances of the protrusions, and the protrusions of each of the solar-cell strings protrude into the depression parts of neighboring solar-cell strings.

11. A method for fabricating a solar cell, **characterized in that**, the method comprises the steps of:
slicing directly a monocrystalline silicon rod prepared by using a czochralski method, to obtain a circular silicon wafer;
performing texturing, diffusing, etching, passivation-film depositing and anti-reflection coating to the silicon wafer;
printing front-surface electrodes and back-surface electrodes at a surface of the silicon wafer, and sintering to obtain a circular cell; and
cutting the circular cell, to obtain sector-shaped solar cells.
